# EUROPÄISCHE PATENTSCHRIFT

(11) **EP 2 714 286 B1**
(45) Veröffentlichungstag und Bekanntmachung des Hinweises auf die Patenterteilung: **02.03.2016**
(21) Anmeldenummer: 12727331.6
(22) Anmeldetag: 25.05.2012
(51) Int. Cl.: B05D 7/24, B05D 1/02, B05D 1/38, H01L 21/67, B05D 3/04, B01D 67/00, B01D 71/00, B05B 7/24

(54) **VORRICHTUNG UND VERFAHREN ZUR HERSTELLUNG VON HOCH PORÖSEN, KRISTALLINEN OBERFLÄCHENBESCHICHTUNGEN**
DEVICE AND METHOD FOR PRODUCING HIGHLY POROUS, CRYSTALLINE SURFACE COATINGS
DISPOSITIF ET PROCÉDÉ DE FABRICATION DE REVÊTEMENTS DE SURFACE CRISTALLINS À FORTE POROSITÉ

(30) Priorität: 27.05.2011 DE 102011050684
(43) Veröffentlichungstag der Anmeldung: 09.04.2014
(73) Patentinhaber: Karlsruher Institut für Technologie, 76344 Eggenstein-Leopoldshafen (DE)
(72) Erfinder: WÖLL, Christof, 76185 Karlsruhe (DE); SHEKHAH, Osama, Thuwal 23955-6900 Jeddah (SA); FRANZREB, Matthias, 76185 Karlsruhe (DE); ARSLAN, Hasan, 44866 Bochum (DE); WOHLGEMUTH, Jonas, 67454 Hassloch (DE); FISCHER, Roland, 44879 Bochum (DE)
(74) Vertreter: Fitzner, Uwe
(86) Internationale Anmeldenummer: PCT/EP2012/059900
(87) Internationale Veröffentlichungsnummer: WO 2012/163854

(56) Entgegenhaltungen:
- WO-A2-2008/030474
- DE-A1-102005 035 762
- US-A1- 2011 064 936
- ZACHER DENISE ET AL: "Thin films of metal-organic frameworks", CHEMICAL SOCIETY REVIEWS, CHEMICAL SOCIETY, LONDON, GB, Bd. 38, Nr. 5, 1. Mai 2009 (2009-05-01), Seiten 1418-1429, XP009142829, ISSN: 0306-0012
- HASAN K. ARSLAN ET AL: "High-Throughput Fabrication of Uniform and Homogenous MOF Coatings", ADVANCED FUNCTIONAL MATERIALS, Bd. 21, Nr. 22, 22. November 2011 (2011-11-22), Seiten 4228-4231, XP55040062, ISSN: 1616-301X, DOI: 10.1002/adfm.201101592

## Beschreibung

Die vorliegende Erfindung betrifft eine Vorrichtung sowie deren Verwendung zur Herstellung von hoch porösen kristallinen Oberflächenbeschichtungen sowie ein Verfahren unter Verwendung der betreffenden Vorrichtung.

Metallorganische Gerüstverbindungen (englisch: Metal-organic frameworks - MOF's) sind hybride anorganisch-organische Feststoffe mit hoher Porösität. Zu ihren herausragenden Eigenschaften zählen hohe Gasspeicherkapazitäten für Wasserstoff und Kohlenwasserstoffe sowie Anwendungspotenziale in den Bereichen Gas-Trennung, Sensorik und Katalyse (Mueller, U.; Schubert, M.; Teich, F.; Puetter, H.; Schierle-Arndt, K; Pastre, J. J. Mater. Chem. 2006, 16, 626-636).

Metall-organische Gerüstverbindungen sind komplexe 2D- bzw. 3-D-Zeolith-ähnliche Netzwerke mit perfekter Translationssymmetrie. Basierend auf der Werner-Typ-Koordinationschemie bestehen metallorganische Gerüstverbindungen aus Metallkationen N^{m+} (m = 2;3) und oligo-funktionalisierten organischen Liganden. Das Design und die präzise Steuerung der Bildung der jeweiligen Netzwerke wurden in der Literatur wiederholt beschrieben und untersucht (G. Ferey, Chem. Soc. Rev., 2008, 37, 191, O.M. Yaghi, M. O'Keeffe, N. W. Ockwig, H.K. Chae, M. Eddaoudi and J. Kim, Nature, 2003, 423, 705, K. Uemura, R. Matsuda and S. Kitagawa, J. Solid State Chem., 2005, 178, 2420-2429).

Während die Produktion pulverförmiger metallorganischer Gerüstverbindungen für Speichermaterialien im halbtechnischen Maßstab durchführbar ist, sind die entsprechenden Verfahren für die Nanotechnologie noch nicht ausreichend. Solche Verfahren sind insbesondere erforderlich für die Herstellung von Membranen, katalytischen Beschichtungen, chemischen Sensoren und anderen nanotechnologischen Anwendungen.

Für zahlreiche Anwendungen der Beschichtung von Substraten mit MOFs werden grundsätzlich bisher drei Möglichkeiten verfolgt:
a) Wachstum bzw. direkte Abscheidung aus solvothermalen Lösungen
b) Die Zusammenführung von zuvor in Lösung gebildeten Nanokristallen auf Oberflächen und
c) das schrittweise (quasi-epitaktische) "Layer-by-Layer"-Wachstum auf eine Oberfläche.
(Zacher, D.; Shekhah, O.; Wöll, C.; Fischer, R.A. Chem. Soc. Rev. 2009, 38, 1418-1429; Shekhah. O.; Materials, 2010, 3, 1302-1315)

Die Herstellung von metallorganischen Gerüstverbindungen erfolgt gewöhnlich durch solvothermale bzw. hydrothermale Verfahren, bei denen aus einer Mischung der Prekursor-Substanzen kristalline MOF-Partikel ausgefällt werden. Für eine Reihe von Applikationen sind derartige pulverförmige Materialien jedoch nicht geeignet.

Die Herstellung von Multilagen-Oberflächenbeschichtungen aus verschiedenen Substanzen wird teilweise durch zyklisches Eintauchen des Substrats in mit gelösten Substanzen gefüllte Reservoire durchgeführt. Ein Beispiel ist das Verfahren zur Herstellung von Polyelektrolytschichten (Gero Decher, et al., Science 1997 277, 1232-1237).

Bei diesem Verfahren resultiert die annähernd monomolekulare Ausbildung der Lagen bei gleichzeitiger Haftung der unterschiedlichen Lagen aufeinander aus der Verwendung entgegengesetzt geladener Polyelektrolyte. Nach der Ausbildung einer monomolekularen Schicht tritt eine elektrostatische Abstoßung auf, die Anlagerung weiterer Moleküle gleicher Ladung ist sodann inhibiert. Wird das Substrat jedoch anschließend in ein zweites Reservoir mit einem Polyelektrolyten entgegengesetzter Ladung getaucht, kommt es zu einer elektrostatischen Anbindung einer Monolage dieser Substanz. Durch einen zyklischen Wechsel des Eintauchens in die beiden Reservoire bildet sich eine definierte Schichtung der Polyelektrolytlagen aus. Die Anordnung der Polyelektrolytmoleküle innerhalb einer Lage weist keinerlei kristallinen Charakter auf.

Neben der Abscheidung solcher Polyelektrolytschichten aus Lösungen gibt es auch die Herstellung von Multilagen-Beschichtungen unter Verwendung von Sprühprozessen. Beispiele sind die Herstellung von Oberflächenbeschichtungen bzw. Filmen durch zyklisches, abwechselndes Aufsprühen von Poly(styrolsulfonat) und Poly(diallyldimethylammonium)-Lösungen (Schlenoff J.; Dubas S.; and Farhat T.; Langmuir 2000; 16; 9968-9969).

Der Sprühprozess erfolgt dabei mittels einfacher, von Hand gepumpter Sprühflaschen. Die resultierenden Filme zeigen eine gleichmäßige Oberfläche und weisen wegen des Einsatzes der Layer by Layer-Technik eine Lagenstruktur mit senkrecht zur Oberfläche orientierten Schichten auf (Izquierdo A.; Ono SS, Voegel J-C.; Schaaf P and Decher G.; Langmuir 2005; 21, 7558-7567; Kolasinska M et al.; Langmuir 2009; 25, 1224-1232; Lu C and Fery A. Chem. Mater. 2006; 18, 6204-6210).

Bekannt ist ferner ein automatisierter Sprühprozess zur Generierung von in der Layer-by-Layer-Technik aufgebrachten Polyelektrolyt-Schichten (siehe z.B. US2011/0064936A1, WO2008/030474A2 und DE102005035762A1) Hierbei erfolgt der Sprühprozess über drei extern gesteuerte Magnetventile und Sprühdüsen, die die Polyelektrolyte bzw. Wasser als Spülmedium sequenziell auf eine Oberfläche sprühen. Die Magnetventile erlauben es dabei, das Sprühen der in Vorratsgefäßen unter Druck stehenden Medien elektronisch an- bzw. abzustellen. Der Druck in den Vorratsgefäßen wird über eine Stickstoffzuleitung und manuell einstellbare Druckregler aufrecht erhalten. Zur Erzeugung der Schichten wurden wiederum Polyelektrolyte, Kombinationen aus Polyelektrolyten mit Nanopartikeln sowie eine Kombination aus Polyacrylsäure und Polyethylenoxid, die über Wasserstoffbrückenbindungen wirken, eingesetzt. Keines dieser Systeme weist aber über Röntgendiffraktometrie nachweisbare kristalline Ordnungen auf.

Aufgabe der vorliegenden Erfindung war es nunmehr, hoch poröse kristalline Oberflächenbeschichtungen mittels eines Sprühverfahrens zu erzeugen. Es sollte die Möglichkeit der Herstellung großflächiger Schichten geschaffen werden. Ferner sollte gegenüber dem bisherigen Verfahren eine Zeitersparnis erreicht werden. D.h. es sollte eine rasche Synthese viellagiger Schichten ermöglicht werden, wobei kürzere Synthesedauern auch zu konstanteren Bedingungen führen. Zugleich sollte eine Materialersparnis sowie ein günstigerer Verteilungskoeffizient zwischen Molekülen in Lösung und Molekülen an der Oberfläche erzielt werden.

Diese Aufgabe wird durch die Vorrichtung zur Herstellung von hoch porösen, kristallinen Oberflächenbeschichtungen, entsprechend dem Gegenstand eines der Ansprüche 1-4, gelöst.

Ferner wird die Aufgabe durch ein Verfahren zur Herstellung von hoch porösen kristallinen Oberflächenbeschichtungen, entsprechend dem Gegenstand eines der Ansprüche 5-13, gelöst.

Den Sprühvorrichtungen werden Precursor-Substanzen zugeführt, aus welchen sich nach dem Aufsprühen auf die Beschichtungsoberfläche die Beschichtungsmaterialien bilden und die mithin der Beschichtung der Oberflächen dienen. Beispielsweise sind die Precursor-Substanzen so ausgelegt, dass eine Kristallbildung erst auf der beschichteten Fläche erfolgt, d.h. erst nachdem die Precursor-Substanzen auf der Oberfläche des Trägermaterials anhaften.

In einer erfindungsgemäß bevorzugten Form sind mindestens zwei, bevorzugt 2 bis 10, insbesondere bevorzugt 2 bis 6, Sprühvorrichtungen vorgesehen, welche der Zufuhr unterschiedlich zusammengesetzter Precursor-Substanzen dienen. Z.B. können über eine Sprühvorrichtung organische Komponenten und über die zweite Sprühvorrichtung Metallionen enthaltende Precursor-Substanzen zugeführt werden. Über eine entsprechende Mess-, Steuer- und Regeltechnik wird die Zuführung der einzelnen Precursor-Substanzen geregelt. Vorzugsweise handelt es sich um druckgesteuerte Regelventile.

Die Sprühvorrichtungen sind auf die Oberfläche des zu beschichtenden Trägermaterials gerichtet. In einer vorzugsweisen Ausführungsform der Erfindung sind die Sprühvorrichtungen horizontal oder nahezu horizontal ausgerichtet. Die Oberfläche des zu beschichtenden Trägermaterials ist vorzugsweise vertikal oder nahezu vertikal ausgerichtet. In einer bevorzugten Anordnung der Erfindung ist das zu beschichtende Material auf einem Probenbehälter angebracht. Z.B. kann die Befestigung mittels Unterdrucks erfolgen. Der Probenbehälter ist in einer Variante der Erfindung temperierbar ausgelegt.

Das Trägergas wird ebenfalls über eine Prozesssteuerung dosiert und den Sprühvorrichtungen zugeführt. Durch die Zufuhr des Trägergases wird eine Vernebelung der Precursor-Substanzlösung erreicht.

Die Precursor-Substanzen werden im Rahmen der vorliegenden Erfindung vor Beginn des eigentlichen Sprühprozesses in einem herkömmlichen Lösungsmitteln, bevorzugt Ethanol, DMF, Wasser gelöst und in die Vorratsbehälter gefüllt.

Die erfindungsgemäße Vorrichtung ermöglicht ein Verfahren, welches im Gegensatz zum Stand der Technik in einem streng kontrollierten Sprühprozess mit einer sequenziellen Abfolge des Aufbringens verschiedener Precursor-Substanzen arbeitet. Im Unterschied zu bisher bekannten Sprühprozessen zur Erzeugung von Polyelektrolyt-Multilagenschichten ergeben sich dabei hinsichtlich der Dosierung und Verteilung der pro Fläche aufzubringenden Substanzmengen sowie der Spülprozesse zwischen dem Aufbringen der Precursor-Substanzen besondere Anforderungen (Erzeugen eines dünnen, sehr gleichmäßigen Flüssigkeitsfilms der Precursorlösung auf dem Trägermaterial, sehr effizienter Spülprozess zur vollständigen Entfernung ungebundener Reste der vorhergegangenen Precursorlösung, strikte Vermeidung eines Kontakts der Precursorlösungen in sämtlichen Anlagenkomponenten wie Ventilen, Schlauchzuführungen, Düsen). Dies wird durch die spezielle erfindungsgemäße Verfahrensweise gewährleistet.

Insbesondere ist es ein entscheidendes Merkmal der vorliegenden Erfindung, dass die durch die erfindungsgemäße Verfahrensweise erzeugten Beschichtungen eine nachweisbare Kristallinität, d.h. strenge dreidimensionale Ordnung aufweisen.

Während die bisher bekannten Sprühprozesse zur Erzeugung von Layer-by-Layer-Anordnungen unter Druck stehende Lösung der Precursor-Substanzen durch eine Düse pressen und dadurch die Zerstäubung erreichen, werden in der vorliegenden Erfindung nach dem Prinzip einer Strahlpumpe die Precursor-Substanzen angesaugt, wobei die o.g. Trägergase verwendet werden. D.h. es wird im Gegensatz zum Stand der Technik eine Zweistoffzerstäubertechnik zur Beschichtung verwendet. Dieses Verfahren ermöglicht die Verwendung von wesentlich geringeren Lösungsmengen als dies bei Druck betriebenen Sprühdüsen möglich ist.

Nach jedem Besprühen der Oberfläche wird diese wiederum gespült, um nicht abreagierte Moleküle der Precursor-Substanzlösung zu entfernen. Im zweiten Schritt wird sodann wieder Precursor-Substanzlösung aufgebracht und im nächsten Schritt wieder gespült. In einer erfindungsgemäß bevorzugten Form wird zunächst eine Komponente, z.B. die organische Komponente enthaltende Precursor-Substanz, aufgebracht. Im zweiten Schritt wird sodann die unterschiedliche Komponente, beispielsweise die Metallionen enthaltene Precursor-Substanz, aufgesprüht. Zwischen jedem Sprühvorgang wird abgespült. Die entsprechenden Sprüh- und Spülprozesse werden so oft wiederholt, bis die gewollte Schichtdicke erreicht ist.

Durch den Sprühprozess bilden sich die Oberflächenbeschichtungen aus. Die Spülung ist erforderlich, um ungebundene Precursor-Moleküle vollständig zu entfernen, bevor die nächste Komponente aufgesprüht wird. Der Spülprozess muss dabei vollständig und zugleich schonend sein, so dass sich das Aufsprühen der Spüllösung hierfür nur bedingt eignet. Die vorliegende Erfindung setzt daher bevorzugt eine Spülvorrichtung ein, die die Spüllösung über eine Pumpe fördert und über einen Flüssigkeitsverteiler auf der Oberfläche aufbringt. Vorzugsweise ist der Verteiler so ausgelegt, dass die Spüllösung vom oberen Ende der beschichteten Oberflächen des vertikal oder nahezu vertikal angeordneten Trägermaterials auf diesem nach unten abläuft.

Die durch den Sprühvorgang und die Spülung anfallende Flüssigkeit wird am Boden gesammelt und abgesaugt.

In einer erfindungsgemäß bevorzugten Form befinden sich Sprühvorrichtung, Spülvorrichtung und Probenhalter in einer geschlossenen Kammer. Es handelt sich hierbei vorzugsweise um eine klimatisierte Kammer, in welcher eine Kontrolle von Temperatur und Luftfeuchtigkeit erfolgt. Beides wird in Abhängigkeit von den Messergebnissen geregelt.

Für die Verwendung flüchtiger Precursor-Substanz-Lösungsmittel können auch besondere Sicherheitsvorkehrungen vorgesehen sein. So kann die Klimakammer mit Stickstoff gespült werden, um die Bildung explosiver Gasgemische zu vermeiden.

Für die Precursor-Substanzen werden im Falle der Metallionen vorzugsweise Acetatverbindungen eingesetzt, da diese bereits in Lösung in einer Konformation vorliegen, die der im späteren Kristallgitter entspricht.

Als organische Komponenten werden vorzugsweise Carboxylate und Pyridinverbindungen eingesetzt.

Als Metallionen werden vorzugsweise Kupfer- Eisen- und/oder Zinkionen, insbesondere Cu(II), Zn(II), Fe(III), eingesetzt

Die Precursor-Substanzen liegen vorzugsweise als Lösungen vor. Als Lösemittel kommt die gesamte Palette herkömmlicher Lösemittel, bevorzugt Ethanol, DMF, Wasser in Betracht.

Als Trägergas kommen vorzugsweise inerte Gase in Betracht. Besonders bevorzugt sind Stickstoff, Argon, Helium.

Als Spülmittel werden erfindungsgemäß insbesondere Ethanol, DMF, Wasser eingesetzt.

Mit dem erfindungsgemäßen Verfahren wird eine Beschichtung erreicht, welche eine geordnete Kristallstruktur aufweist. Die entstehende Schicht ist hoch porös mit Porositäten zwischen 8 bis 50 Angström. Die Erfindung erlaubt erstmals die schnelle und sichere Herstellung homogen kristalliner und hoch poröser Beschichtungen.

Als Anwendungsmöglichkeiten wird auf die einfache und direkte Herstellung von Sensoren durch Beschichten von Elektroden für Quarzkristallwaagen hingewiesen. Ferner ist der Einschluss katalytisch hochwirksamer metallischer Nanocluster in poröse Gerüste möglich. Die MOF-Struktur ermöglicht einen Kontakt der Reaktanten mit dem Katalysator bei gleichzeitiger Verhinderung einer Agglomeration oder Ablösung der Nanocluster. Die Generierung neuartiger Membranen mit eindeutig definierter Porenstruktur und Ausrichtung wird durch die erfindungsgemäßen Verfahren ebenfalls ermöglicht.

Im Folgenden wird die Erfindung unter Bezugnahme auf die Figuren näher erläutert:
- Figur 1: zeigt ein Beispiel einer erfindungsgemäß einsetzbaren Anlage.

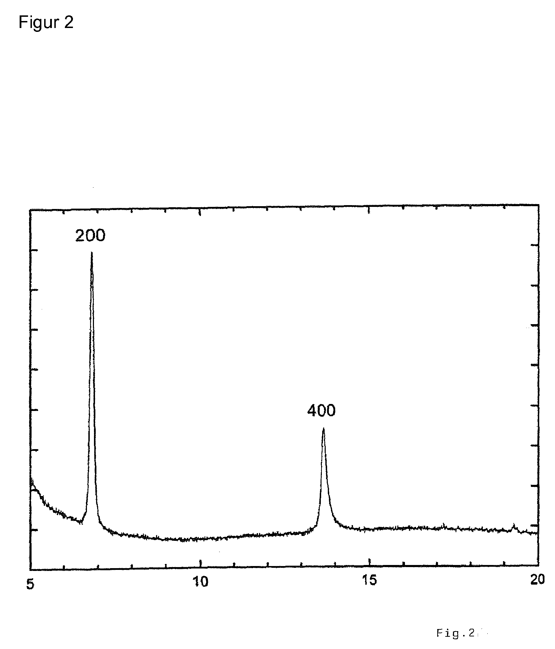

- Figur 2: zeigt das Ergebnis des Röntgendiffraktogramms gemäß Beispiel 1 (HKUST - 1 (40 Lagen) auf einer COOH-funktionalisierten Oberfläche).

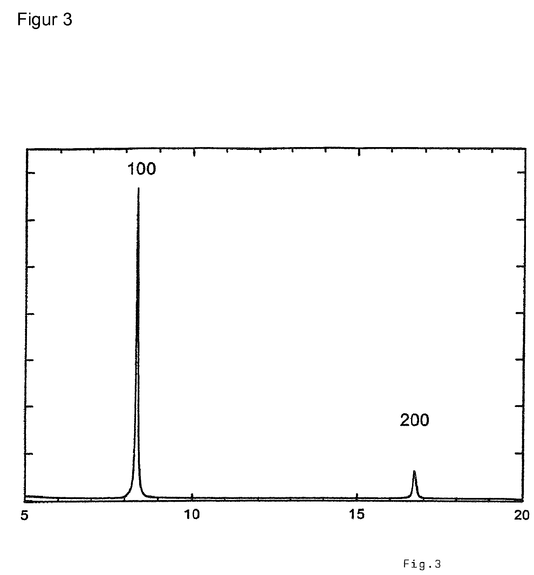

- Figur 3: zeigt das Röntgendiffraktogramm gemäß Beispiel 2 (Cu₂(bdc)₂ MOF (40 Lagen) auf einer COOH-funktionalisierten Oberfläche).

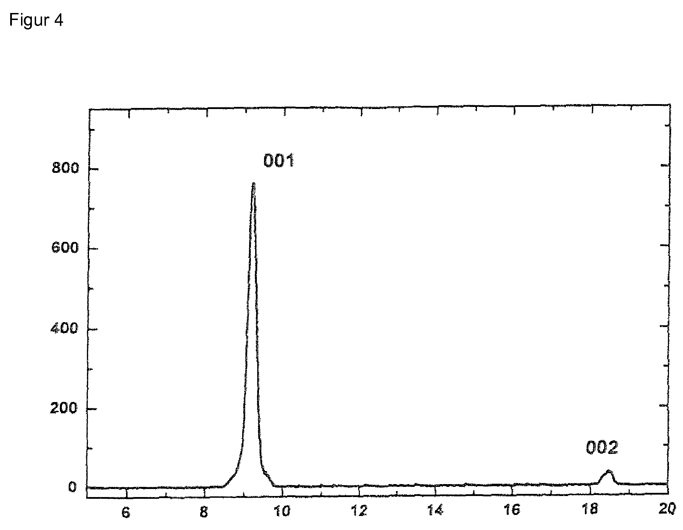

- Figur 4: zeigt das Röntgendiffraktogramm gemäß Beispiel 3 (Cu₂(bdc)₂(dabco) MOF (20 Lagen) auf einer Pyridin-funktionalisierten Oberfläche).

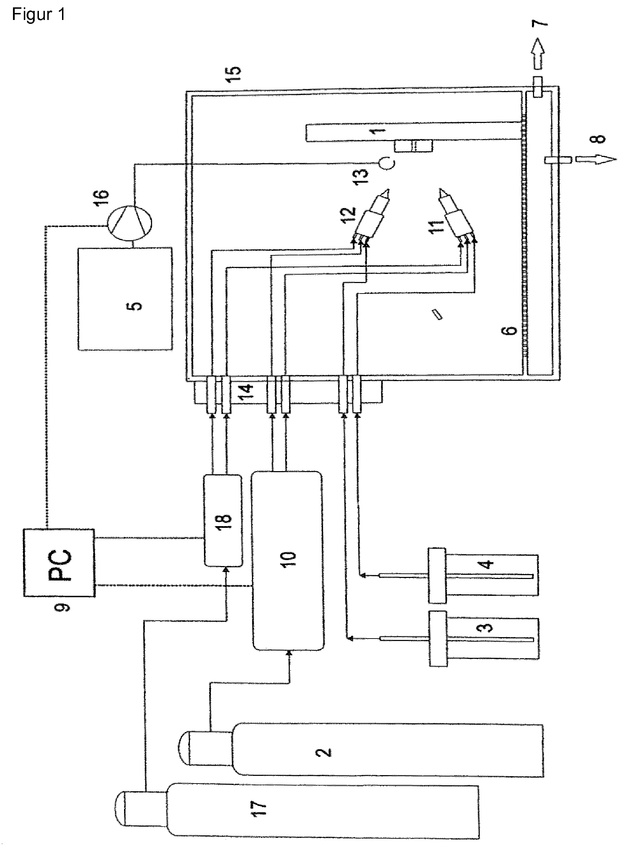

Die Bezugszeichen in Figur 1 haben folgende Bedeutung:
- 1: temperier- und verfahrbare Vakuumhalteeinheit.
- 2: Gasflasche für Inertgas.
- 3: Vorlagegefäß für die Precursor-Substanz enthaltend Komponente A.
- 4: Vorlagegefäß für die Precursor-Substanz enthaltend Komponente B.
- 5: Vorlage für Spüllösung.
- 6: Perforierte Bodenplatte.
- 7: Anschluss zum Absaugen von Gas.
- 8: Ablass für Flüssigkeiten.
- 9: PC mit Steuerungssoftware.
- 10: Ventil-Prüf- bzw. Prüfverteiler mit Kommunikation zum PC.
- 11: Sprühvorrichtung für die Precursor-Substanz enthaltend Komponente A.
- 12: Sprühvorrichtung für die Precursor-Substanz enthaltend Komponente B.
- 13: Auslassdüse für Spüllösung.
- 14: Wanddurchführung mit Schnellverbindern.
- 15: temperierbare Klimakammer.
- 16: Pumpe für Spüllösung.
- 17: Stickstoffversorgung für Druckluftventile.
- 18: Steuerblock für Druckluftventile.

Die Sprühvorrichtungen 11 und 12 können unter Einsatz eines inerten Gases 2 die Precursor-Substanzen mit den Komponenten A und B tropfenfrei auf eine Oberfläche aufnebeln. Die Komponenten A und B sind voneinander verschiedene chemische Verbindungen. Z.B. kann A die organische Komponente und B die Metallionen enthaltende Komponente sein. Diese werden über die Sprühvorrichtung 11 und 12 getrennt aufgebraucht, d.h. Komponente A über die Sprühvorrichtung 11 und Komponente B über die Sprühvorrichtung 12. Die Spülvorrichtung 13 erlaubt mit ihrer Vorlage 5 und der Pumpe 16 die Zufuhr von Spüllösung zur vollständigen Entfernung ungebundener Precursor-Moleküle, ohne die aufgesprühten Schichten negativ zu beeinflussen. Hierfür wird mittels der Pumpe 16 aus der Vorlage 5 Spüllösung auf die beschichtete Oberfläche aufgebracht.

Die Sprühvorrichtungen 11 und 12 sind mit den Vorratsgefäßen 3 und 4 verbunden. Durch die Zuführung von Trägergas aus dem Vorratsbehälter 2 wird nach dem Prinzip einer Strahlpumpe Lösung an Precursor-Substanzen aus den Vorratsbehältern 3 und 4 angesaugt. Die Öffnung der Precursor-Substanz-Zuführung an den Sprühvorrichtungen 11 und 12 erfolgt über druckluftgesteuerte Regelventile. Dagegen kann die Zufuhr von Trägergas über die computergesteuerte Prozesssteuerung 9 und 10 erfolgen. Die Vorrichtung 10 ist hierbei ein Ventil- bzw. Sprühverteiler, welcher über einen PC 9 gesteuert wird.

Das Material, dessen Oberfläche beschichtet werden soll, ist vertikal auf dem Probenhalter 1 angebracht. Das Material wird an diesen mittels Unterdruck angesaugt.

Die Spülvorrichtung 13 ist derart angeordnet, dass aus ihr austretende Spülmittel an der Oberfläche des beschichteten Materials vom oberen Ende her entlang läuft und so nicht abreagierte Precursor-Substanz-Moleküle abgespült werden. Ablaufende Spüllösungen laufen über die perforierte Bodenplatte 6 ab. Über die Öffnung 8 können die Flüssigkeiten abgesaugt werden.

In der erfindungsgemäßen Anlage gemäß Figur 1 sind Probenhalter 1, Spülvorrichtung 13 sowie Beschichtungsvorrichtungen 11 und 12 in einer Klimakammer 15 angeordnet, in welcher Temperatur und Luftfeuchtigkeit kontrolliert und geregelt werden können.

Die Vorrichtung gemäß Figur 1 enthält auch konstruktive Elemente zur Verwendung flüchtiger Precursor-Substanz-Lösungsmittel, z.B. von Ethanol. Hierfür ist die Absaugvorrichtung 7 vorgesehen. D. h. mittels dieser Vorrichtung kann die Klimakammer 15 mittels Stickstoff gespült werden, um die Bildung explosiver Gasgemische zu vermeiden.

Alle Anschlüsse an die Klimakammer können über die Schnellkupplungen 14 bewerkstelligt werden.

### Beispiel 1:

Herstellung des MOF Cu₃(btc)₂ x H₂O HKUST-1 (40 Lagen) auf einer COOH funktionalisierten Oberfläche. (btc = 1,3,5-Benzentricarboxylsäure; HKUST = Hong-Kong University of Science and Technology).

Als Vorbereitung für den Versuch wurde auf einem goldbedampften Stück (ca. 15x20 mm) eines Siliziumwafers durch Eintauchen in eine Mercaptohexadecansäure-(MHDA)-Lösung für 48 Stunden eine selbstassemblierte Monolage (SAM) erzeugt. Nach dem Eintauchen wurde die Probe mit Ethanol gespült und anschließend mit Stickstoff getrocknet.

Für den Sprühprozess wurde zuerst Cu(CH₃COO)₂-Lösung für 15 Sekunden auf die SAM gesprüht. Als zweite Substanz wurde für 25 Sekunden mit BTC (Benzentricarboxylsäure) gesprüht. Zwischen jedem Sprühschritt wurde die Probe mit Ethanol gespült. Insgesamt wurden 40 Zyklen der beschriebenen Abfolge durchgeführt. Die resultierende Probe wurde getrocknet und mittels XRD analysiert. Das resultierende Röntgendiffraktogramm zeigt zwei scharfe Intensitätspeaks, die den streng kristallinen und räumlich geordneten Charakter der gebildeten Schicht belegen. Die entsprechenden Schichten bestehen aus 40 Lagen.

### Beispiel 2:

Herstellung des MOF Cu₂(bdc)₂ (40 Lagen) auf einer COOH funktionalisierten Oberfläche (bdc = 1,4 Benzoldicarboxylsäure).

Als Vorbereitung für den Versuch wurde auf einem goldbedampften Stück (ca. 15x20 mm) eines Siliziumwafers durch Eintauchen in eine Mercaptohexadecansäure-(MHDA)-Lösung für 48 Stunden ein SAM erzeugt. Nach dem Eintauchen wurde die Probe mit Ethanol gespült und anschließend mit Stickstoff getrocknet.

Für den Sprühprozess wurde zuerst Cu(CH₃COO)₂-Lösung für 15 Sekunden auf die SAM gesprüht. Als zweite Substanz wurde für 25 Sekunden mit bdc (bdc = 1,4-Benzendicarboxylsäure) gesprüht. Zwischen jedem Sprühschritt wurde die Probe mit Ethanol gespült. Insgesamt wurden 40 Zyklen der beschriebenen Abfolge durchgeführt. Die resultierende Probe wurde getrocknet und mittels XRD analysiert. Insgesamt ergab sich eine 40-lagige Beschichtung. Die resultierenden sehr scharfen Intensitätspeaks belegen auch für diesen zweiten MOF-Typ den streng kristallinen und räumlich geordneten Charakter der gebildeten Schicht.

### Beispiel 3:

Herstellung des MOF Cu₂(ndc)₂ (dabco) (20 Lagen) auf einer Pyridin funktionalisierten Oberfläche (20 Zyklen [Cu₂(ndc)₂(dabco)] auf Pyridin-SAM).

Als Vorbereitung für den Versuch wurde auf einem goldbedampften Stück (ca. 15x20 mm) eines Siliziumwafers durch Eintauchen in eine 4,4-Pyridyl-benzolmethanthiol (PBMT)-Lösung für 30 Minuten ein SAM erzeugt. Nach dem Eintauchen wurde die Probe mit Ethanol gespült und anschließend mit Stickstoff getrocknet.

Für den Sprühprozess wurde zuerst Cu (CH₃COO) ₂-Lösung für 15 Sekunden auf die SAM gesprüht. Als zweite Substanz wurde für 25 Sekunden mit einer 1:1 Mischung aus ndc (ndc = 1,4-Naphtalindicarboxylsäure) und dabco = 1,4-Diazabicyclo [2.2.2] octan gesprüht.
Zwischen jedem Sprühschritt wurde die Probe mit Ethanol gespült.
Insgesamt wurden 20 Zyklen der beschriebenen Abfolge durchgeführt. Die resultierende
Probe wurde getrocknet und mittels XRD analysiert.
Insgesamt ergab sich eine 20-lagige Beschichtung.

In diesem Beispiel wurde durch Änderung des zugrunde liegenden SAMs eine andere räumliche Ausrichtung des entstehenden Kristallgitters erreicht.

## Patentansprüche

1. Vorrichtung zur Herstellung von hoch porösen, kristallinen Oberflächenbeschichtungen unter Verwendung einer Zweistoffzerstäubertechnik mit wenigstens zwei mit einer sequenziellen Abfolge arbeitenden Sprühvorrichtungen, über welche unter Zuführung von Trägergas aus einem Vorratsbehälter (2) verschiedener Precursor-Substanzen zur Herstellung der Oberflächenbeschichtungen aus den Vorratsgefäßen (3, 4) auf die Oberfläche eines zu beschichtenden Trägermaterials aufgetragen werden und mit wenigstens einer Spülvorrichtung (5, 13, 16) zur Entfernung ungebundener Moleküle von der beschichteten Oberfläche,
wobei die Precursor-Substanzen nach dem Prinzip einer Strahlpumpe angesaugt werden.

2. Vorrichtung nach Anspruch 1 **dadurch gekennzeichnet, dass** das Trägermaterial auf einen Probenhalter (1) angeordnet ist.

3. Vorrichtung nach einem der vorhergehenden Ansprüche **dadurch gekennzeichnet, dass** sie Regel- und Steuervorrichtungen für die Zufuhr des Trägergases (9, 10) aus dem Vorratsbehälter (2) und die Zufuhr von Precursor-Substanzen aus den Vorratsgefäßen (3, 4) aufweist.

4. Vorrichtung nach einem der vorhergehenden Ansprüche **dadurch gekennzeichnet, dass** der Probenaufnahmebehälter (2) und die Sprühvorrichtungen (11, 12) und die Spülvorrichtung (5) in einem geschlossenen Raum (15) angeordnet sind, dessen Temperatur und Luftfeuchtigkeit gemessen, gesteuert und geregelt wird.

5. Verfahren zur Herstellung von hoch porösen kristallinen Oberflächenbeschichtungen, bei welchem
a) Precursor-Substanzen mittels Sprühvorrichtungen (11, 12) unter Zuführung von Trägergas aus einem Vorratsbehälter auf eine Oberfläche eines Trägermaterials aufgebracht,
b) mittels Spülvorrichtungen (5, 13, 18) ungebundene Moleküle von der beschichteten Oberfläche abgespült,
c) weitere Precursor-Substanzen mittels der Sprühvorrichtungen (11, 12) aufgebracht,
d) mittels der Spülvorrichtungen (5, 13, 18) ungebundene Moleküle von der beschichteten Oberfläche abgespült,
e) die Schritte a) bis d) wiederholt werden, bis die gewünschten Dicken der Oberflächenschichten erreicht sind,
**dadurch gekennzeichnet, dass**
man mit einer sequenziellen Abfolge des Aufbringens verschiedener Precursor-Substanzen arbeitet, und
wobei zur Beschichtung der Oberfläche eine Zweistoffzerstäubertechnik verwendet wird, bei der die Precursor-Substanzen nach dem Prinzip einer Strahlpumpe angesaugt werden.

6. Verfahren nach Anspruch 5 **dadurch gekennzeichnet, dass** in den einzelnen Verfahrensschritten wenigstens zwei voneinander verschiedene Precursor-Substanzen eingesetzt werden.

7. Verfahren nach Anspruch 6 **dadurch gekennzeichnet, dass** eine Precursor-Substanz organische und eine weitere Precursor-Substanz Metallionen enthält.

8. Verfahren nach Anspruch 7 **dadurch gekennzeichnet, dass** als organische Komponente 1,3,5-Benzentricarboxylsäure, 1,4-Benzoldicarboxylsäure oder Naphthalindicarboxylsäure eingesetzt werden.

9. Verfahren nach Anspruch 7 **dadurch gekennzeichnet, dass** als Metallionen Cu(II), Zn(II), Fe(III) eingesetzt werden.

10. Verfahren nach einem der Ansprüche 5 bis 9 **dadurch gekennzeichnet, dass** die Precursor-Substanzen unter Einsatz von Trägergas in Form von in dem Gas fein verteilten Flüssigkeitstropfen aufgebracht werden.

11. Verfahren nach Anspruch 10 **dadurch gekennzeichnet, dass** als Trägergas inertes Gas eingesetzt wird.

12. Verfahren nach Anspruch 11 **dadurch gekennzeichnet, dass** als Trägergas Stickstoff, Argon und/oder Helium eingesetzt wird.

13. Verfahren nach einem der Ansprüche 5 bis 12 **dadurch gekennzeichnet, dass** als Spülmittel Ethanol, Wasser und/oder DMF eingesetzt wird.

14. Verwendung der Vorrichtung nach einem der Ansprüche 1 bis 4 zur Herstellung hoch poröser kristalliner Oberflächenbeschichtungen.

## Claims

1. A device for producing highly porous, crystalline surface coatings comprising at least two spraying devices which work with a sequential sequence and by way of which various precursor substances for producing the surface coatings are applied to the surface of a carrier material to be coated from the storage vessels (3, 4) while supplying carrier gas from a storage container (2), and comprising at least one rinsing device (5, 13, 16) for removing unbound molecules from the coated surface,
whereby the precursor substances are sucked in on the principle of an aspirator.

2. The device as claimed in claim 1, **characterized in that** the carrier material is arranged on a sample holder (1).

3. The device as claimed in one of the preceding claims, **characterized in that** it has regulating and control devices for the supply of the carrier gas (9, 10) from the storage container (2) and the supply of precursor substances from the storage vessels (3, 4).

4. The device as claimed in one of the preceding claims, **characterized in that** the sample receiving container (2) and the spraying devices (11, 12) and the rinsing device (5) are arranged in a closed space (15), the temperature and atmospheric humidity of which are measured, controlled and regulated.

5. A method for producing highly porous crystalline surface coatings, in which
a) precursor substances are applied to a surface of a carrier material by means of spraying devices (11, 12) while supplying carrier gas from a storage container,
b) unbound molecules are rinsed off from the coated surface by means of rinsing devices (5, 13, 18),
c) further precursor substances are applied by means of the spraying devices (11, 12),
d) unbound molecules are rinsed off from the coated surface by means of the rinsing devices (5, 13, 18),
e) steps a) to d) are repeated until the desired thicknesses of the surface layers are achieved,
**characterized in that**
the method works with a sequential sequence of applying various precursor substances, and **in that** a two-substance atomizer technique is used for the coating and the precursor substances are sucked in on the principle of an aspirator.

6. The method as claimed in claim 5, **characterized in that** at least two precursor substances that are different from one another are used in the individual method steps.

7. The method as claimed in claim 6, **characterized in that** one precursor substance contains organic and a further precursor substance contains metal ions.

8. The method as claimed in claim 7, **characterized in that** 1,3,5-benzenetricarboxylic acid, 1,4-benzenedicarboxylic acid or naphthalenedicarboxylic acid are used as the organic component.

9. The method as claimed in claim 7, **characterized in that** Cu(II), Zn(II), Fe(III) are used as metal ions.

10. The method as claimed in one of claims 5 to 9, **characterized in that**, with the use of carrier gas, the precursor substances are applied in the form of liquid drops that are finely distributed in the gas.

11. The method as claimed in claim 10, **characterized in that** inert gas is used as the carrier gas.

12. The method as claimed in claim 11, **characterized in that** nitrogen, argon and/or helium is used as the carrier gas.

13. The method as claimed in one of claims 5 to 12, **characterized in that** ethanol, water and/or DMF is used as the rinsing agent.

14. The use of the device as claimed in one of claims 1 to 4 for producing highly porous crystalline surface coatings.

## Revendications

1. Dispositif pour la production de revêtements de surface hautement poreux, cristallins, sous utilisation d'une technique de pulvérisation de deux substances, présentant au moins deux dispositifs de pulvérisation travaillant dans un ordre séquentiel, via lesquels différentes substances de précurseur pour la production des revêtements de surface sont appliquées, sous alimentation de gaz support à partir d'un réservoir (2), à partir des réservoirs (3, 4) sur la surface d'un matériau support à revêtir, et présentant au moins un dispositif de rinçage (5, 13, 16) pour l'élimination de molécules non liées de la surface revêtue, les substances de précurseur étant aspirées selon le principe d'une pompe à jets.

2. Dispositif selon la revendication 1, **caractérisé en ce que** le matériau support est disposé sur un porte-échantillon (1).

3. Dispositif selon l'une quelconque des revendications précédentes, **caractérisé en ce qu'**il présente des dispositifs de régulation et de commande pour l'alimentation en gaz support (9, 10) à partir du réservoir (2) et pour l'alimentation en substances de précurseur à partir des réservoirs (3, 4).

4. Dispositif selon l'une quelconque des revendications précédentes, **caractérisé en ce que** le réservoir (2) et les dispositifs de pulvérisation (11, 12) et le dispositif de rinçage (5) sont disposés dans un espace fermé (15) dont la température et l'humidité sont mesurées, commandées et régulées.

5. Procédé pour la production de revêtements de surface hautement poreux, cristallins, dans lequel
a) des substances de précurseur sont appliquées au moyen de dispositifs de pulvérisation (11, 12), sous alimentation en gaz support à partir d'un réservoir, sur la surface d'un matériau support,
b) des molécules non liées sont éliminées par rinçage de la surface revêtue au moyen de dispositifs de rinçage (5, 13, 18),
c) d'autres substances de précurseur sont appliquées au moyen des dispositifs de pulvérisation (11, 12),
d) des molécules non liées sont éliminées par rinçage de la surface revêtue au moyen des dispositifs de rinçage (5, 13, 18),
e) les étapes a) à d) sont répétées jusqu'à ce que les épaisseurs souhaitées des couches de surface soient obtenues,
**caractérisé en ce qu'**on travaille avec un ordre séquentiel de l'application des différentes substances de précurseur, une technique de pulvérisation de deux substances étant utilisée pour le revêtement de la surface, lors de laquelle les substances de précurseur sont aspirées selon le principe d'une pompe à jets.

6. Procédé selon la revendication 5, **caractérisé en ce qu'**on utilise, dans les différentes étapes de procédé, au moins deux substances de précurseur différentes l'une de l'autre.

7. Procédé selon la revendication 6, **caractérisé en ce qu'**une substance de précurseur contient des composants organiques et une autre substance de précurseur contient des ions métalliques.

8. Procédé selon la revendication 7, **caractérisé en ce qu'**on utilise, comme composant organique, de l'acide 1,3,5-benzènetricarboxylique, de l'acide 1,4-benzènedicarboxylique ou de l'acide naphtalènedicarboxylique.

9. Procédé selon la revendication 7, **caractérisé en ce qu'**on utilise, comme ions métalliques, Cu(II), Zn(II), Fe(III).

10. Procédé selon l'une quelconque des revendications 5 à 9, **caractérisé en ce que** les substances de précurseur sont appliquées, sous utilisation de gaz support, sous forme de gouttes liquides finement réparties dans le gaz.

11. Procédé selon la revendication 10, **caractérisé en ce qu'**on utilise, comme gaz support, un gaz inerte.

12. Procédé selon la revendication 11, **caractérisé en ce qu'**on utilise, comme gaz support, de l'azote, de l'argon et/ou de l'hélium.

13. Procédé selon l'une quelconque des revendications 5 à 12, **caractérisé en ce qu'**on utilise, comme agent de rinçage, de l'éthanol, de l'eau et/ou du DMF.

14. Utilisation du dispositif selon l'une quelconque des revendications 1 à 4 pour la production de revêtements de surface hautement poreux, cristallins.
